# EUROPÄISCHE PATENTSCHRIFT

(11) **EP 3 521 844 B1**
(45) Veröffentlichungstag und Bekanntmachung des Hinweises auf die Patenterteilung: **16.10.2024**
(21) Anmeldenummer: 19155203.3
(22) Anmeldetag: 04.02.2019
(51) Int. Cl.: G01R 31/52

(54) **TACHOGRAFENANORDNUNG, VERFAHREN ZUM BETREIBEN EINER TACHOGRAFENANORDNUNG**
TACHOGRAPH, METHOD FOR OPERATING A TACHOGRAPH
TACHYGRAPHE, PROCÉDÉ DE FONCTIONNEMENT D'UN TACHOGRAPHE

(30) Priorität: 05.02.2018 DE 102018201736
(43) Veröffentlichungstag der Anmeldung: 07.08.2019
(73) Patentinhaber: Continental Automotive Technologies GmbH, 30175 Hannover (DE)
(72) Erfinder: Rombach, Gerhard, 78098 Triberg (DE); Peduzzi, Carlo, 78050 Villingen (DE); Meitzner, Michael, 78086 Brigachtal (DE)
(74) Vertreter: Continental Corporation

(56) Entgegenhaltungen:
- DE-A1- 102007 055 442
- DE-A1- 102016 207 321
- US-A- 5 257 407
- US-A1- 2009 280 753

## Beschreibung

In vielen Ländern sind heutzutage digitale Fahrtenschreiber (Tachografen) in neu zugelassenen Fahrzeugen, insbesondere in Fahrzeugen zum Gütertransport oder auch in Bussen, vorgeschrieben. Digitale Tachografen können neben den grundsätzlichen Funktionen, wie beispielsweise dem Erfassen und Aufzeichnen der Fahrtstrecke und der Fahrtzeit, häufig auch zusätzliche Funktionen ausführen, wie beispielsweise das Berechnen von Lenk- und Ruhezeiten. Elektronische Tachografen ermöglichen zudem eine moderne und einfache Art der Fahrerauthentifizierung. Jeder Fahrer erhält dazu eine Fahrerkarte, (z.B. eine Chipkarte) auf der seine persönlichen Daten gespeichert sind. Diese Karte wird vor dem Beginn der Fahrt in den Tachograf eingeführt, welcher dann die folgenden Fahrten genau dem Eigentümer der Fahrerkarte zuordnet. Dabei speichert der Tachograf die ermittelten Daten in einem internen Speicher, aus dem später die Daten heruntergeladen werden können.

Dabei muss die ordnungsgemäße Funktion des Tachografen zu jedem Zeitpunkt sichergestellt sein. Fehler oder Manipulationen im Fahrtenschreiber sollten möglichst schnell und zuverlässig erkannt werden. Daher sind entlang von Autobahnen an verschiedenen Stellen Portale (z.B. Empfangsbrücken oder -baken) angeordnet. Eine so genannte On-board Unit, welche im Fahrzeug installiert ist, kommuniziert dabei mit den Portalen, und teilt diesen mit, wenn Anhaltspunkte für einen Fehler bzw. eine Manipulation des Tachografen vorliegen. Fahrzeuge, deren Tachografen als möglicherweise fehlerhaft erkannt wurden, können dann im Rahmen von Verkehrskontrollen angehalten und auf die korrekte Funktion des Tachografen überprüft werden. Die Kommunikation zwischen Portal und Fahrzeug basiert dabei in Europa beispielsweise auf der so genannten "Dedicated Short Range Communication" (DSRC). In anderen Ländern können andere Kommunikationsstandards zum Einsatz kommen.

Die für die Kommunikation mit dem Portal verwendete Antenne muss im Fahrzeug meist an der Windschutzscheibe, am Fahrzeugdach oder am Seitenspiegel befestigt sein, um eine ungestörte Kommunikation mit den Portalen zu gewährleisten. Die Elektronik (der Tachograf) kann jedoch dabei entfernt von der Antenne im Fahrzeug angeordnet sein, z.B. im Armaturenbrett. Wird die Antenne entfernt von der Elektronik angeordnet, können jedoch möglicherweise Daten nicht oder nicht korrekt zwischen Antenne und Elektronik übertragen werden. Das heißt, die Funktionssicherheit kann möglicherweise nicht gewährleistet sein. Zudem kann die Verbindung möglicherweise manipuliert werden.

Die Druckschrift US 5,257,407 A offenbart ein Kommunikationssystem mit einem Subsystem, mehreren Sendern und mehreren mobilen Sendeempfängern. Ein Antennenkoppler und ein Positionssensor sind über ein Koaxialkabel miteinander gekoppelt. Der Vorspannungsstrom zu dem Koppler wird von dem Positionssensor über einen Widerstand geliefert. Ein Detektor misst die Spannung über dem Widerstand, die relativ zu dem in dem Antennenkoppler fließenden Strom ist. Der Detektor vergleicht die gemessene Spannung über zwei Komparatoren und bestimmt, ob die gemessene Spannung eine bestimmte Grenze überschreitet.

Die Druckschrift DE 10 2016 207 321 A1 offenbart eine Antennenanordnung mit einer Antenneneinheit und einer mit der Antenneneinheit verbundenen Sende-/Empfangseinheit. Die Sende-/Empfangseinheit weist eine Verarbeitungseinheit auf, die dazu ausgebildet ist, ein von der Antenneneinheit empfangenes Signal zu verarbeiten und Signale an die Antenneneinheit auszusenden. Die Sende-/Empfangseinheit weist weiterhin eine Abwärtsstrecke und eine Aufwärtsstrecke auf, wobei die Abwärtsstrecke dazu ausgebildet ist, Signale von der Antenneneinheit an die Verarbeitungseinheit zu übertragen, und wobei die Aufwärtsstrecke dazu ausgebildet ist, Signale von der Verarbeitungseinheit an die Antenneneinheit zu übertragen. Die Sende-/Empfangseinheit weist auch eine Umschalteinheit auf, die dazu ausgebildet ist, die Aufwärts- und die Abwärtsstrecke zu trennen, wobei die Aufwärtsstrecke und die Abwärtsstrecke parallel zueinander zwischen die Umschalteinheit und die Verarbeitungseinheit geschaltet sind. Eine Vorspannungseinheit ist in der Abwärtsstrecke zwischen der Umschalteinheit und der Verarbeitungseinheit angeordnet und ist dazu ausgebildet, einen Vorstrom oder eine Vorspannung bereitzustellen.

Die Druckschrift US 2009/0280753 A1 offenbart ein Verfahren zum Prüfen der Integrität einer Antennenanordnung eines Senders, wobei der Sender eine Sendertreiberstufe zum Treiben der Antennenanordnung mit einem Treiberstrom aufweist.

Aufgabe der Erfindung ist es, eine Antennenanordnung und eine On-board Unit mit einer Antennenanordnung bereitzustellen, welche eine erhöhte Funktionssicherheit und Manipulationssicherheit aufweisen.

Diese Aufgabe wird durch eine Tachografenanordung gemäß Anspruch 1 sowie ein Verfahren gemäß Anspruch 8 gelöst. Ausgestaltungen und Weiterbildungen des Erfindungsgedankens sind Gegenstand von abhängigen Ansprüchen.

Es wird eine Tachografenanordnung umfassend eine Antennenanordnung mit einer Antenne und einer Verarbeitungseinheit offenbart, wobei die Antenne und die Verarbeitungseinheit mittels einer Verbindungsleitung miteinander verbunden sind. Die Antennenanordnung weist weiterhin eine Diagnoseeinheit auf, die dazu ausgebildet ist, eine Spannung der Verbindungsleitung, welche an einem Eingang der Verarbeitungseinheit anliegt, zu bestimmen und einen Fehler zu detektieren, wenn die bestimmte Spannung vorgegebene Kriterien erfüllt.

Dadurch können sowohl die Funktionssicherheit als auch die Manipulationssicherheit erhöht werden.

Der Fehler kann ein Kurzschluss in der Verbindungsleitung oder eine Unterbrechung der Verbindungsleitung sein.

Derartige Fehler sind die häufigsten und schwerwiegendsten Fehler in der Verbindungsleitung zu der Antenne.

Ein Kurzschluss in der Verbindungsleitung kann beispielsweise detektiert werden, wenn die bestimmte Spannung 0V beträgt. Eine Unterbrechung der Verbindungsleitung kann hingegen beispielsweise dann detektiert werden, wenn die bestimmte Spannung 3,2V beträgt.

Beispielsweise können zusätzliche Maßnahmen ergriffen werden, wenn ein Fehler detektiert wurde und sich die Verarbeitungsarbeit in einem Betriebszustand befindet, welcher kein Standby-Zustand ist.

In anderen Zuständen als einem Standby-Zustand, in welchem in der Regel alle wesentlichen Komponenten deaktiviert sind, kann es hilfreich sein, zusätzliche Maßnahmen zu ergreifen. Zusätzliche Maßnahmen können beispielsweise das Erzeugen einer Warnung und/oder das Speichern einer Fehlermeldung in einem Speicher sein. Dadurch kann beispielsweise ein Fahrer über den detektierten Fehler informiert werden, so dass die Verbindungsleitung sofort überprüft werden kann. Das Abspeichern des Fehlers in einem Fehlerspeicher ermöglicht es, den Fehler auch zu einem späteren Zeitpunkt noch nachvollziehen zu können.

Das Erzeugen einer Warnung kann dabei wenigstens eines aufweisen von einer visuellen Warnung und einer akustischen Warnung.

Die Diagnoseeinheit umfasst wenigstens einen Analog-Umsetzer, der dazu ausgebildet ist, eine Spannung in der Verbindungsleitung zu bestimmen und einen Fehler zu detektieren, wenn die bestimmte Spannung vorgegebene Kriterien erfüllt. So kann auf einfach Art und Weise ein Fehler erkannt werden.

Die Diagnoseeinheit weist zwei Analog-Umsetzer auf, die parallel zueinander zwischen ein Ende der Verbindungsleitung und eine erste Verarbeitungseinheit geschaltet sind und die dazu ausgebildet sind, jeweils unterschiedliche Fehler zu detektieren. Für jeden möglichen Fehler kann somit ein separater Analog-Umsetzer vorgesehen sein.

Die Antenne und die Verarbeitungseinheit können entfernt voneinander angeordnet sein. Beispielsweise kann die Verbindungsleitung zwischen der Antenne und der Verarbeitungseinheit eine Länge von etwa einem Meter oder mehr aufweisen.

Weiterhin wird ein Verfahren zum Betreiben einer Tachografenanordnung mit einer Antenne und einer Verarbeitungseinheit offenbart. Das Verfahren weist das Bestimmen einer Spannung einer Verbindungsleitung zwischen der Antenne und der Verarbeitungseinheit mittels einer Diagnoseeinheit, wobei die Spannung an einem Eingang der Verarbeitungseinheit anliegt, und das Detektieren eines Fehlers auf, wenn die bestimmte Spannung vorgegebene Kriterien erfüllt.

Die Erfindung wird nachfolgend anhand der Figuren der Zeichnung näher erläutert, wobei gleiche oder ähnliche Elemente mit denselben Bezugszeichen versehen sind. Es zeigt:
- Figur 1: in einem Blockschaltbild eine Antennenanordnung, bei der die Antenne und die Elektronik entfernt voneinander angeordnet sind,
- Figur 2: in einem Blockschaltbild eine Antennenanordnung in einem Fahrzeug, bei der die Antenne entfernt von der Elektronik angeordnet ist,
- Figur 3: in einem Blockschaltbild ein Beispiel einer Antennenanordnung gemäß der vorliegenden Erfindung,
- Figur 4: in einem Blockschaltbild ein Beispiel einer Verbindung zwischen einer Bake und einer Antennenanordnung gemäß der vorliegenden Erfindung,
- Figur 5: in einem Blockschaltbild ein Beispiel einer Antennenanordnung gemäß der vorliegenden Erfindung, und
- Figur 6: in einem Ablaufdiagram ein Beispiel eines Verfahrens zum Betreiben einer Antennenanordnung.

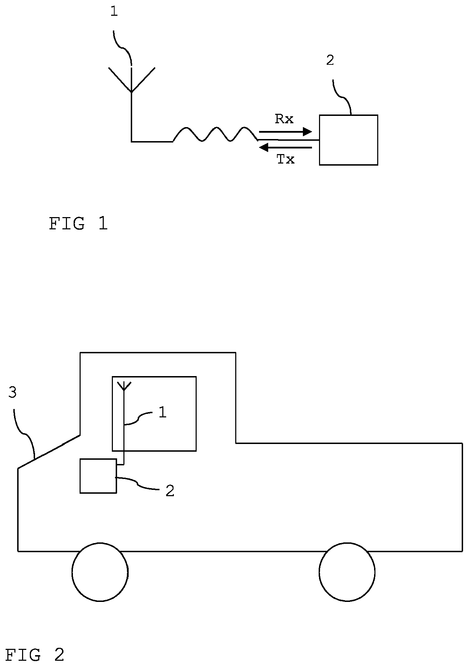

Figur 1 zeigt in einem Blockschaltbild eine Antennenanordnung. Die Antennenanordnung weist eine Antenne 1 auf, die dazu ausgebildet ist, Signale zu empfangen und zu senden. Die Antennenanordnung weist weiterhin eine Verarbeitungseinheit 2 auf. Über eine Abwärtsstrecke Rx können Signale von der Antenne 1 an die Verarbeitungseinheit 2, und über eine Aufwärtsstrecke Tx können Signale von der Verarbeitungseinheit 2 an die Antenne 1 gesendet werden. In Figur 1 sind Abwärts- und Aufwärtsstrecke Rx, Tx nicht getrennt voneinander dargestellt, sondern durch dieselbe Verbindungsleitung zwischen Antenne 1 und Verarbeitungseinheit 2.

Die Verarbeitungseinheit 2 kann beispielsweise Teil einer Tachografenanordnung sein und kann, wie in Figur 2 dargestellt, in einem Fahrzeug 3 angeordnet sein. Die Tachografenanordnung kann beispielsweise verschiedene Daten des Fahrzeugs 3 und des zugehörigen Fahrers aufzeichnen. Beispielsweise kann ein Tachograf die gefahrene Strecke, die gefahrene Geschwindigkeit, Lenkzeiten und Ruhezeiten des Fahrzeugs 3 aufzeichnen. Dies sind jedoch lediglich Beispiele. Ein Tachograf kann meist noch wesentlich mehr Daten in Bezug auf das Fahrzeug 3 und den Fahrer aufzeichnen. Die Bestimmung und die Aufzeichnung der Daten kann in der Verarbeitungseinheit 2 erfolgen. Die Verarbeitungseinheit 2 kann jedoch auch mit weiteren Komponenten verbunden sein, welche dazu ausgebildet sind, die Daten zu erfassen und aufzuzeichnen. Beispielsweise kann die Verarbeitungseinheit 2 eine Sende-/Empfangseinheit sein, die dazu ausgebildet ist, über die Antenne 1 empfangene Signale zu verarbeiten und zu sendende Signale an die Antenne 1 auszugeben.

Die Antenne 1 kann beispielsweise Signale von einem Portal oder einer Bake empfangen. Solche Portale finden sich beispielsweise in regelmäßigen Abständen entlang von Autobahnen. Solche Portale können beispielsweise Mautportale sein, welche zur Mauterhebung genutzt werden. Die Portale können jedoch für Tachografenanwendungen mit benutzt werden. Die von einem solchen Portal ausgesendeten Signale haben nur eine begrenzte Reichweite, z.B. 50m. Die Antennenanordnung empfängt Signale von einem Portal, wenn sie sich innerhalb der entsprechenden Reichweite befindet. Außerhalb der Reichweite werden von der Antennenanordnung keine Signale empfangen. Bewegt sich ein Fahrzeug 3 auf einer Straße, entlang welcher Portale angeordnet sind, so empfängt die in dem Fahrzeug 3 angeordnete Antennenanordnung in regelmäßigen Abständen Signale, nämlich immer dann, wenn sich das Fahrzeug 3 in der Nähe eines Portals befindet (z.B. an diesem vorbei fährt).

Die Kommunikation zwischen Portal und Antennenanordnung erfolgt in Europa in der Regel gemäß dem DSRC-Standard. Eine Kommunikation nach dem DSRC-Standard erfolgt nach dem Master-Slave Prinzip mit einer Frequenz von etwa 5,8 Gigahertz (in europäischen Ländern), wobei das Portal der Master ist. Das heißt, Kommunikationen werden ausschließlich durch das Portal angestoßen. Die Antennenanordnung sendet lediglich Antwortsignale aus, wenn sie entsprechende Anfragesignale eines Portals empfängt. Entsprechende Normen für die DSRC-Kurzstrecken-Funkkommunikation werden in Europa vom europäischen Komitee für Normung (CEN) festgelegt, welches beispielsweise die verfügbaren Frequenzbänder, wie auch Protokolle und Kommunikationsstandards festlegt.

Die Antenne 1 und die Verarbeitungseinheit 2 können, wie in Figur 1 beispielhaft dargestellt, entfernt voneinander angeordnet sein. Entfernt voneinander angeordnet bedeutet in diesem Zusammenhang, dass eine Verbindung zwischen der Antenne 1 und der Verarbeitungseinheit 2 eine Länge von etwa einem Meter oder mehr (z.B. bis zu 7m) aufweist. Die entfernte Verbindung wird in Figur 1 dabei durch die Wellenform der Verbindung zwischen der Antenne 1 und der Verarbeitungseinheit 2 dargestellt.

Bezugnehmend auf Figur 2 ist eine Antennenanordnung in einem Fahrzeug 3 dargestellt. Das Fahrzeug 3 kann beispielsweise ein LKW, PKW, Bus, Motorrad o.ä. sein. Die Antennenanordnung kann, wie bereits erläutert, Teil einer Tachografenanordnung sein. Dabei kann die Verarbeitungseinheit 2 innerhalb des Fahrzeugs 3, beispielsweise im Armaturenbrett angeordnet sein. Die Antenne 1 ist jedoch meist in der Nähe von Fahrzeugscheiben oder des Fahrzeugdaches, und somit entfernt von der Verarbeitungseinheit 2, angeordnet, um eine ungestörte Kommunikation mit den Portalen entlang von Straßen zu ermöglichen. Die gesendeten Signale könnten durch die Fahrzeugkarosserie zu stark abgeschirmt und somit geschwächt werden, wenn die Antenne 1 ebenfalls beispielsweise im Armaturenbrett angeordnet wäre.

Wird die Verarbeitungseinheit 2 entfernt von der Antenne 1 angeordnet, können leichter Beschädigungen an der notwendigerweise langen Verbindungsleitung (den Kabeln) auftreten als bei kurzen Entfernungen, so dass Signale möglicherweise nicht oder nur teilweise zwischen der Antenne 1 und der Verarbeitungseinheit 2 gesendet werden können. Zudem können Kurzschlüsse in der Antenne 1 oder in den Leitungen auftreten, welche sich ebenfalls negativ auf die Signalübertragung auswirken. Verbindungsleitungen können möglicherweise komplett offen sein, das heißt, es ist gar keine Verbindung zwischen der Antenne 1 und der Verarbeitungseinheit 2 gegeben.

Gerade bei Tachografenanwendungen muss jedoch zu jedem Zeitpunkt gewährleistet werden, dass die Daten korrekt übertragen werden können. Ebenso muss es jederzeit möglich sein, die Funktion des Tachografen überprüfen zu können.

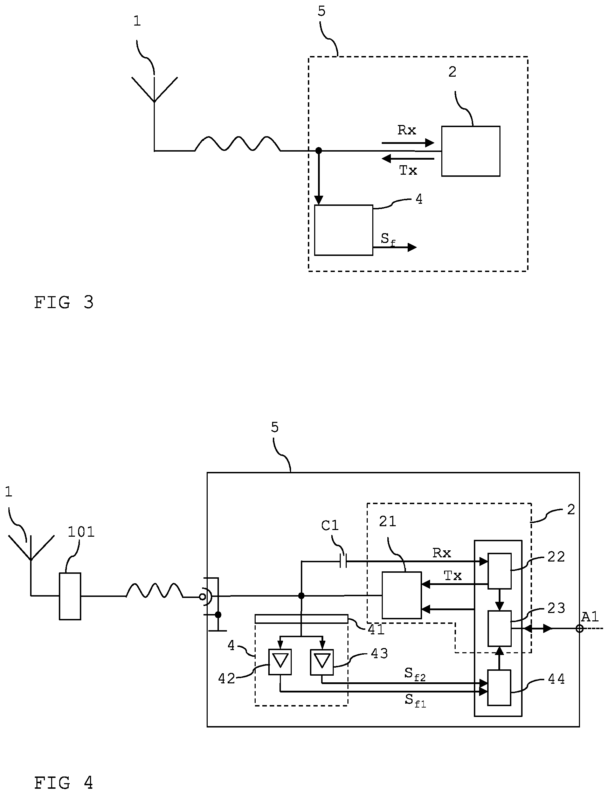

Daher ist es gemäß der vorliegenden Erfindung vorgesehen, die Verbindung zwischen Antenne 1 und Verarbeitungseinheit 2 zyklisch und/oder kontinuierlich zu überprüfen, um mögliche Fehler zu detektieren. Dadurch können entsprechende Auflagen in Bezug auf die funktionale Sicherheit erfüllt werden. Mögliche Fehler, die bei der Überprüfung detektiert werden können, sind beispielsweise eine offene oder eine kurzgeschlossene Leitung. Um derartige Fehler detektieren zu können, kann beispielsweise eine Spannung in der Verbindungsleitung bestimmt werden. Insbesondere kann eine Spannung bestimmt werden, welche am Eingang des Tachografen bzw. einer Steuereinheit 5 (z.B. Electronic Control Unit, ECU) des Tachografen anliegt, mit welcher die Verbindungsleitung verbunden wird (vgl. z.B. Figur 3) . Dadurch können Kurzschlüsse erkannt werden. Es kann weiterhin beispielsweise auch erkannt werden, wenn die Verbindungsleitung nicht oder nicht korrekt mit dem Eingang der Steuereinheit 2 verbunden wurde oder gar keine Verbindungsleitung vorhanden ist.

Neben der Spannung in der Verbindungsleitung kann beispielsweise auch die Antennen-Charakteristik bestimmt werden. Hierfür können beispielsweise die Signalreflexion oder die Rückflussdämpfung und das Stehwellenverhältnis bestimmt werden.

Wie beispielhaft in Figur 3 dargestellt, kann die Antennenanordnung eine Diagnoseeinheit 4 aufweisen. Die Diagnoseeinheit 4 kann die Spannung der Verbindungsleitung an einem ersten Ende bestimmen und ein entsprechendes Fehlersignal S_{f} ausgeben. Das Fehlersignal S_{f} kann an weitere Komponenten oder Einheiten (in Figur 3 nicht dargestellt) zur weiteren Auswertung gesendet werden. Beispielsweise kann das Fehlersignal S_{f} zwei verschiedene Zustände aufweisen. Nimmt das Fehlersignal S_{f} einen ersten Zustand an (z.B. *"*0*"* oder Low), wurde beispielsweise kein Fehler erkannt. Das Fehlersignal S_{f} kann einen zweiten Zustand annehmen (z.B. *"*1*"* oder High), wenn ein Fehler detektiert wurde.

Wenn ein Fehler erkannt wurde, können optional verschiedene Maßnahmen ergriffen werden. Beispielsweise kann auf einem Display im Fahrzeug 3 eine Warnmeldung ausgegeben werden und der Fahrer darauf hingewiesen werden, dass ein Fehler an der Verbindungsleitung zur Antenne detektiert wurde. Das Anzeigen einer Warnmeldung auf einem Display ist jedoch lediglich ein Beispiel. Es könnte auch eine entsprechende Warnleuchte aufleuchten oder ein Warnton ausgegeben werden. Der Fahrer kann die Leitung dann schnellstmöglich überprüfen oder mit dem Fahrzeug 3 zur Überprüfung in eine Werkstatt fahren. Alternativ oder zusätzlich kann eine entsprechende Information in einem Speicher des Tachografen abgelegt werden. So kann zu einem späteren Zeitpunkt beim Auslesen des Speichers nachvollzogen werden, dass ein Fehler erkannt wurde.

Dabei kann jedoch zusätzlich auch beispielsweise ein Betriebszustand des Tachografen mit berücksichtigt werden. Beispielsweise kann sich der Tachograf in einem Standby-Zustand befinden. Das heißt, das Fahrzeug 3 ist beispielsweise nicht in Bewegung und die Zündung wurde nicht betätigt, so dass der Tachograf nicht benötigt wird. Wird der Tachograf nicht benötigt nachdem das Fahrzeug 3 abgestellt wurde, kann er in den Standby-Zustand wechseln, um Energie zu sparen. Im Standby-Zustand können alle oder zumindest ein Teil der Komponenten des Tachografen ausgeschaltet sein. Im normalen Betrieb des Fahrzeugs befindet sich der Tachograf normalerweise in einem Ein-Zustand. Das heißt, sämtliche Komponenten des Tachografen sind aktiviert. Beispielsweise bei Fahrzeugen 3 für den Gefahrguttransport können noch weitere Betriebszustände des Tachografen vorgesehen sein.

Solche Betriebszustände ergeben sich beispielsweise aus den Vorgaben des ADR (Accord européen relatif au transport international des marchandises Dangeuereuses par Route, deutsch: Europäisches Übereinkommen über die internationale Beförderung gefährlicher Güter auf der Straße). Dieses legt beispielsweise fest, dass Fahrzeuge für den Gefahrguttransport einen Hauptschalter aufweisen müssen. Der Hauptschalter ist während der Fahrt zu schließen. Nachdem das Fahrzeug abgestellt wurde, bzw. beim Be- und Entladen ist der Schalter zu öffnen. Durch Öffnen des Hauptschalters können bestimmte vorgeschriebene Einheiten (z.B. Tachograf) zumindest teilweise deaktiviert werden. Durch eine Deaktivierung der Verarbeitungseinheit 2 beim Öffnen des Hauptschalters wird beispielsweise verhindert, dass der Tachograf beim Be- und Entladen mit anderen externen Geräten (z.B. Baken) drahtlos kommuniziert. Die Antenne 1 und vorhandene Komponenten, die zum Senden und Empfangen von Signalen benötigt werden, müssen während des Be- und Entladens gemäß ADR ausgeschaltet sein. Jedoch müssen einzelne andere Komponenten des Tachografen während des Be- und Entladens aktiv sein, da das Be- und Entladen als Arbeitszeit zählt und auch als solche im Tachografen abzuspeichern ist. Das heißt, der Tachograf befindet sich beim Be- oder Entladen von Gefahrguttransporten weder im Standby-Zustand noch im Ein-Zustand, sondern vielmehr in einem Zwischenzustand. Weitere Betriebszustände können möglich sein.

Im Standby-Zustand ist ein Fehlersignal S_{f} beispielsweise nicht relevant und kann ignoriert werden. Es können, wenn sich der Tachograf im Standby-Zustand befindet, beispielsweise keine weiteren Maßnahmen getroffen werden, auch wenn ein Fehler an der Verbindungsleitung zur Antenne 1 erkannt wurde. So kann beispielsweise in diesem Fall keine Warnmeldung erzeugt werden. Wird jedoch beispielsweise die Zündung des Fahrzeugs 3 betätigt oder der Hauptschalter geschlossen und der Tachograf somit zumindest teilweise eingeschaltet, können weitere Maßnahmen ergriffen werden, falls ein Fehler erkannt wurde. Auch wenn zu irgendeinem Zeitpunkt während des Betriebs ein Fehler erkannt wird, können weitere Maßnahmen ergriffen werden. Während des Be- und Entladevorgangs bei Gefahrguttransporten können beispielsweise ebenfalls weitere Maßnahmen ergriffen werden, wenn ein Fehler erkannt wurde. Um die Betriebszustände des Tachografen mit einzubeziehen, können verschiedene geeignete Algorithmen Anwendung finden.

Die Bestimmung von Fehlern in der Verbindungsleitung kann dabei rückwirkungsfrei erfolgen. Das heißt, die Diagnoseeinheit 4 beeinflusst die von der Antenne 1 empfangenen bzw. die von der Verarbeitungseinheit 2 gesendeten Signale nicht. Aufgrund der langen Verbindungsleitung können von der Antenne 1 empfangene Signale nur sehr schwach sein, wenn sie am Eingang des Tachografen anliegen. Bereits eine geringe Rückwirkung der Messung könnte erhebliche Auswirkungen auf die Signale haben und diese verfälschen.

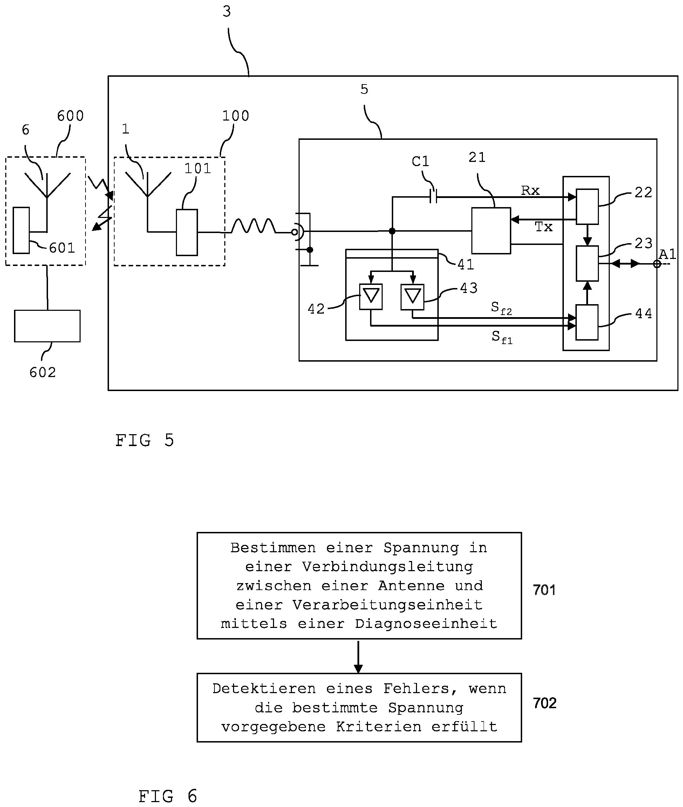

Figur 4 zeigt beispielhaft eine Steuereinheit 5 eines Tachografen. Die Steuereinheit 5 ist über eine lange Verbindungsleitung mit der Antenne 1 Verbunden. Der Antenne 1 kann beispielsweise ein Modulator/Demodulator 101 vorgeschaltet sein. Der Eingang der Steuereinheit 5, an welcher die Verbindungsleitung angeschlossen wird, kann beispielsweise geerdet sein. Ein von der Antenne 1 empfangenes Signal kann über einen Kondensator C1 an einen Eingang einer Signalverarbeitungseinheit 22 gesendet werden. Das Signal kann beispielsweise ein Anfragesignal einer Bake sein. Eine solche Bake 600 ist beispielhaft in Figur 5 dargestellt. Die Anordnungen der Figuren 4 und 5 unterscheiden sich im Wesentlichen nur dadurch, dass in Figur 5 zusätzlich die Bake 600 mit möglichen darin erforderlichen Komponenten dargestellt ist.

Das von der Antenne 1 empfangene Signal kann in der Signalverarbeitungseinheit 22 ausgewertet werden. Die Signalverarbeitungseinheit 22 kann weiterhin dazu ausgebildet sein, ein Antwortsignal zu generieren. Beispielsweise können auf das empfangene Anfragesignal die angeforderten Daten bzw. Informationen aufmoduliert werden. Auf diese Weise können Informationen über möglicherweise detektierte Fehler in der Tachografeneinheit an die Bake 600 gesendet werden. In der Aufwärtsstrecke Tx kann weiterhin ein Signaltreiber 21 angeordnet sein. Die Abwärtsstrecke Rx und die Aufwärtsstrecke Tx können parallel zueinander zwischen den Eingang der Steuereinheit 5 und die Signalverarbeitungseinheit 22 geschaltet sein. Die Diagnoseeinheit 4 kann ebenfalls mit dem Eingang der Steuereinheit 5 verbunden sein. Dabei kann zwischen dem Eingang der Steuereinheit 5 und der Diagnoseeinheit 4 ein ESD-Schutz (ESD = electrostatic discharge) 41 vorgesehen sein.

Die Diagnoseeinheit 4 kann einen ersten Analog-Umsetzer 42 und einen zweiten Analog-Umsetzer 43 aufweisen, die parallel zueinander zwischen den Eingang der Steuereinheit 5 und eine erste Auswerteeinheit 44 geschaltet sind. Der erste Analog-Umsetzer 42 kann dazu ausgebildet sein, einen ersten Fehler zu detektieren, z.B. einen Kurzschluss in der Verbindungsleitung, und der zweite Analog-Umsetzer 43 kann dazu ausgebildet sein, einen zweiten Fehler zu detektieren, z.B. eine offene Verbindungsleitung. Der erste Analog-Umsetzer 42 und der zweite Analog-Umsetzer 43 können beispielsweise jeweils einen Operationsverstärker aufweisen. Die Operationsverstärker können beispielsweise rückwirkungsfreie Operationsverstärker sein.

Verschiedene Fehlerzustände an der Verbindungsleitung können anhand der am Eingang der Steuereinheit 5 bestimmten Spannung voneinander unterschieden werden. Ist die Spannung am Eingang der Steuereinheit 5 Null Volt, ist dies beispielsweise ein Zeichen dafür, dass ein Kurzschluss in der Verbindungsleitung vorliegt. Eine Spannung von beispielsweise etwa 3,2V ist ein Hinweis darauf, dass eine offene Verbindungsleitung vorliegt. Der erste Analog-Umsetzer 42 kann beispielsweise ein erstes Fehlersignal S_{f1} an die erste Auswerteeinheit 44 ausgeben. Das erste Fehlersignal S_{f1} kann beispielsweise zwei verschiedene Werte annehmen, z.B. einen Low-Zustand (*"*0*"*) und einen High-Zustand (*"*1*"*). Detektiert der erste Analog-Umsetzer 42 am Eingang der Steuereinheit 5 eine Spannung von 0V, kann das erste Fehlersignal S_{f1} beispielsweise einen ersten Zustand annehmen (z.B. *"*1*"*). Solange kein Kurzschluss detektiert wird, die bestimmte Spannung sich also von Null unterscheidet, kann das erste Fehlersignal S_{f1} einen zweiten Zustand annehmen (z.B. *"*0*"*).

Das selbe gilt für den zweiten Analog-Umsetzer 43. Dieser kann jedoch dazu ausgebildet sein, eine offene Verbindungsleitung zu detektieren. Das heißt, ein zweites Fehlersignal S_{f2}, welches von dem zweiten Analog-Umsetzer 43 erzeugt wird, kann einen ersten Zustand annehmen (z.B. *"*1*"*) , wenn eine Spannung von etwa 3,2V und somit eine offene Verbindungsleitung detektiert wurde. Das zweite Fehlersignal S_{f2} kann einen zweiten Zustand annehmen (z.B. *"*0*"*), wenn sich die bestimmte Spannung von 3,2V unterscheidet.

Die erste Auswerteeinheit 44 kann die Fehlersignale S_{f1}, S_{f2} auswerten. Weisen die Fehlersignale Sf₁, S_{f2} jeweils den zweiten Zustand auf (kein Fehler detektiert), kann die erste Auswerteeinheit 44 beispielsweise nichts weiter unternehmen. Nimmt jedoch eines der beiden Fehlersignale den ersten Zustand an, wurde also ein Fehler detektiert, kann die erste Auswerteeinheit 44 diese Information an eine zweite Auswerteeinheit 23 senden. Die zweite Auswerteeinheit 23 kann dann unter Berücksichtigung des momentanen Betriebszustands (z.B. aktiv oder Standby) entweder nichts unternehmen oder weitere Maßnahmen ergreifen (z.B. Fahrer benachrichtigen). Die zweite Auswerteeinheit 23 kann beispielsweise mit der Signalverarbeitungseinheit 22 verbunden sein. Der zweiten Auswerteeinheit 23 ist somit bekannt, ob die Signalverarbeitungseinheit 22 aktiv ist und Signale empfangen und verarbeiten kann, oder inaktiv ist (z.B. Standby-Zustand) und keine Signale empfangen und verarbeiten kann. Die zweite Verarbeitungseinheit 23 kann auch mit weiteren Komponenten des Tachografen verbunden sein (nicht dargestellt).

Wird zusätzlich zu der Spannung in der Verbindungsleitung die Antennen-Charakteristik bestimmt, kann diese ebenfalls von der Verarbeitungseinheit 23 mit berücksichtigt werden. Bei zusätzlicher Bestimmung der Antennen-Charakteristik stehen mehr Messwerte zur Verfügung, wodurch die Genauigkeit der Diagnose bzw. Analyse weiter erhöht werden kann. Welche Parameter von der Verarbeitungseinheit 23 berücksichtigt werden, kann beispielsweise davon abhängen, welche Software Verwendung findet.

Über einen Ausgang A1 der Steuereinheit 5 kann die zweite Verarbeitungseinheit 23 mit weiteren Komponenten des Tachografen oder des Fahrzeugs 3 verbunden sein. Beispielsweise kann die zweite Verarbeitungseinheit 23 mit einem Display verbunden sein. Wird ein Fehler detektiert und befindet sich der Tachograf beispielsweise nicht in einem Standby-Zustand, kann die zweite Verarbeitungseinheit 23 ein entsprechendes Signal an ein Display senden, so dass dem Fahrer eine entsprechende Meldung auf dem Display angezeigt wird. Wie bereits oben beschrieben, kann der Fahrer beispielsweise auf jegliche andere Art und Weise über den detektierten Fehler informiert werden.

Weiterhin kann die Information auch an die Signalverarbeitungseinheit 22 gesendet werden. Empfängt diese ein Anfragesignal, kann eine entsprechende Information über den detektierten Fehler in einem Antwortsignal mitgesendet werden.

Eine Bake 600 kann wie in Figur 5 beispielhaft dargestellt beispielsweise eine Antenne 6 und einen Modulator/Demodulator 601 aufweisen. Die Bake 600 kann mit einer Ausleseeinheit 602 verbunden werden. Bei einer Überprüfung von Fahrzeugen können beispielsweise über die Ausleseeinheit 602 die von den an der Bake 600 vorbeifahrenden Fahrzeugen 3 gesendeten Informationen ausgelesen und überprüft werden. Wird von einem Fahrzeug 3 die Information empfangen, dass ein Fehler detektiert wurde, kann dieses Fahrzeug 3 beispielsweise angehalten und sorgfältig überprüft werden.

Figur 6 zeigt beispielhaft in einem Ablaufdiagramm ein Verfahren zum Betreiben einer Antennenanordnung mit einer Antenne 1 und einer Verarbeitungseinheit 2. Das Verfahren weist das Bestimmen einer Spannung in einer Verbindungsleitung zwischen der Antenne 1 und der Verarbeitungseinheit 2 mittels einer Diagnoseeinheit 4 auf (Schritt 701). Das Verfahren weist weiterhin das Detektieren eines Fehlers auf, wenn die bestimmte Spannung vorgegebene Kriterien erfüllt (Schritt 702).

## Patentansprüche

1. Tachografenanordnung umfassend eine Antennenanordnung mit einer Antenne (1) und einer Verarbeitungseinheit (2),
wobei die Antenne (1) und die Verarbeitungseinheit (2) mittels einer Verbindungsleitung miteinander verbunden sind; und
wobei die Antennenanordnung weiterhin eine Diagnoseeinheit (4) aufweist, die dazu ausgebildet ist, eine Spannung in der Verbindungsleitung, und zwar eine Spannung, welche an einem Eingang einer Steuereinheit (5) eines Tachografen, mit welcher die Verbindungsleitung verbunden ist, anliegt, zu bestimmen und einen Fehler zu detektieren, wenn die bestimmte Spannung vorgegebene Kriterien erfüllt;
wobei zusätzliche Maßnahmen ergriffen werden, wenn ein Fehler detektiert wurde und sich die Verarbeitungseinheit (2) in einem Betriebszustand befindet, welcher kein Standby-Zustand ist, wobei die zusätzlichen Maßnahmen wenigstens eines aufweisen von:
Erzeugen einer Warnung; und
Speichern einer Fehlermeldung in einem Speicher;
und wobei die Diagnoseeinheit (4) wenigstens einen Analog-Umsetzer (42, 43) aufweist, der dazu ausgebildet ist, die Spannung in der Verbindungsleitung zu bestimmen und den Fehler zu detektieren, wenn die bestimmte Spannung die vorgegebenen Kriterien erfüllt, wobei die Diagnoseeinheit (4) zwei Analog-Umsetzer (42, 43) aufweist, die parallel zueinander zwischen ein Ende der Verbindungsleitung und eine erste Verarbeitungseinheit (44) geschaltet sind und dazu ausgebildet sind, jeweils unterschiedliche Fehler zu detektieren.

2. Tachografenanordnung nach Anspruch 1, wobei der Fehler ein Kurzschluss in der Verbindungsleitung oder eine Unterbrechung der Verbindungsleitung ist.

3. Tachografenanordnung nach Anspruch 2, wobei ein Kurzschluss in der Verbindungsleitung detektiert wird, wenn die bestimmte Spannung 0 V beträgt.

4. Tachografenanordnung nach Anspruch 2 oder 3, wobei eine Unterbrechung der Verbindungsleitung detektiert wird, wenn die bestimmte Spannung 3,2 V beträgt.

5. Tachografenanordnung nach einem der vorhergehenden Ansprüche, wobei das Erzeugen einer Warnung wenigstens eines aufweist von:
einer visuellen Warnung; und
einer akustischen Warnung.

6. Tachografenanordnung nach einem der vorhergehenden Ansprüche, wobei die Antenne (1) und die Verarbeitungseinheit (2) entfernt voneinander angeordnet sind.

7. Tachografenanordnung nach Anspruch 6, wobei die Verbindungsleitung zwischen der Antenne (1) und der Verarbeitungseinheit (2) eine Länge von etwa einem Meter oder mehr aufweist.

8. Verfahren zum Betreiben einer Antennenanordnung mit einer Antenne (1) und einer Verarbeitungseinheit (2), welche Antennenanordnung Teil einer Tachografenanordnung nach einem der vorhergehenden Ansprüche ist, das Verfahren weist auf:
Bestimmen einer Spannung in einer Verbindungsleitung zwischen der Antenne (1) und der Verarbeitungseinheit (2), und zwar einer Spannung, welche an einem Eingang einer Steuereinheit (5) eines Tachografen, mit welcher die Verbindungsleitung verbunden ist, anliegt, mittels einer Diagnoseeinheit (4); und
Detektieren eines Fehlers, wenn die bestimmte Spannung vorgegebene Kriterien erfüllt;
wobei zusätzliche Maßnahmen ergriffen werden, wenn ein Fehler detektiert wurde und sich die Verarbeitungseinheit (2) in einem Betriebszustand befindet, welcher kein Standby-Zustand ist, wobei die zusätzlichen Maßnahmen wenigstens eines aufweisen von:
Erzeugen einer Warnung; und
Speichern einer Fehlermeldung in einem Speicher;
und wobei die Diagnoseeinheit (4) wenigstens einen Analog-Umsetzer (42, 43) aufweist, der die Spannung in der Verbindungsleitung bestimmt und den Fehler detektiert, wenn die bestimmte Spannung die vorgegebenen Kriterien erfüllt, wobei die Diagnoseeinheit (4) zwei Analog-Umsetzer (42, 43) aufweist, die parallel zueinander zwischen ein Ende der Verbindungsleitung und eine erste Verarbeitungseinheit (44) geschaltet sind und dazu ausgebildet sind, jeweils unterschiedliche Fehler zu detektieren.

9. Verfahren nach Anspruch 8, wobei das Verfahren ferner aufweist: Bestimmen der Antennen-Charakteristik.

## Claims

1. Tachograph arrangement encompassing an antenna arrangement having an antenna (1) and a processing unit (2),
the antenna (1) and the processing unit (2) being connected to one another by means of a connecting line; and
the antenna arrangement furthermore comprising a diagnostics unit (4) that is configured to determine a voltage in the connecting line, specifically a voltage that is applied to an input of a control unit (5) of a tachograph, to which control unit the connecting line is connected, and to detect a fault if the determined voltage meets predefined criteria;
wherein additional measures are taken if a fault has been detected and the processing unit (2) is in an operating state that is not a standby state, the additional measures comprising at least one from:
generating a warning; and
storing an error message in a memory;
and wherein the diagnostics unit (4) comprises at least one analogue converter (42, 43) that is configured to determine the voltage in the connecting line and to detect the fault if the determined voltage meets the predefined criteria, the diagnostics unit (4) comprising two analogue converters (42, 43) that are connected in parallel with one another between one end of the connecting line and a first processing unit (44) and are configured to each detect different faults.

2. Tachograph arrangement according to Claim 1, wherein the fault is a short circuit in the connecting line or an interruption in the connecting line.

3. Tachograph arrangement according to Claim 2, wherein a short circuit in the connecting line is detected if the determined voltage is 0 V.

4. Tachograph arrangement according to Claim 2 or 3, wherein an interruption in the connecting line is detected if the determined voltage is 3.2 V.

5. Tachograph arrangement according to one of the preceding claims, wherein the generation of a warning comprises at least one from:
a visual warning; and
an audible warning.

6. Tachograph arrangement according to one of the preceding claims, wherein the antenna (1) and the processing unit (2) are arranged remotely from one another.

7. Tachograph arrangement according to Claim 6, wherein the connecting line between the antenna (1) and the processing unit (2) has a length of approximately one metre or more.

8. Method for operating an antenna arrangement having an antenna (1) and a processing unit (2), which antenna arrangement is part of a tachograph arrangement according to one of the preceding claims, the method comprising:
determining a voltage in a connecting line between the antenna (1) and the processing unit (2), specifically a voltage that is applied to an input of a control unit (5) of a tachograph, to which control unit the connecting line is connected, by means of a diagnostics unit (4); and
detecting a fault if the determined voltage meets predefined criteria;
wherein additional measures are taken if a fault has been detected and the processing unit (2) is in an operating state that is not a standby state, the additional measures comprising at least one from:
generating a warning; and
storing an error message in a memory;
and wherein the diagnostics unit (4) comprises at least one analogue converter (42, 43) that determines the voltage in the connecting line and detects the fault if the determined voltage meets the predefined criteria, the diagnostics unit (4) having two analogue converters (42, 43) that are connected in parallel with one another between one end of the connecting line and a first processing unit (44) and are configured to each detect different faults.

9. Method according to Claim 8, the method further comprising:
determining the antenna characteristic.

## Revendications

1. Arrangement de tachygraphe comprenant un arrangement d'antenne avec une antenne (1) et une unité de traitement (2),
l'antenne (1) et l'unité de traitement (2) étant reliées entre elles au moyen d'une ligne de connexion ; et
l'arrangement d'antenne possédant en outre une unité de diagnostic (4), laquelle est configurée pour déterminer une tension dans la ligne de connexion, à savoir une tension qui est appliquée à une entrée d'une unité de commande (5) d'un tachygraphe à laquelle est reliée la ligne de connexion, et pour détecter un défaut lorsque la tension déterminée remplit des critères prédéfinis ;
des mesures supplémentaires étant prises lorsqu'un défaut a été détecté et que l'unité de traitement (2) se trouve dans un état de fonctionnement qui n'est pas un état de veille, les mesures supplémentaires présentant au moins l'une des suivantes :
génération d'un avertissement ; et
enregistrement d'un message d'erreur dans une mémoire ;
et l'unité de diagnostic (4) possédant au moins un convertisseur analogique (42, 43), lequel est configuré pour déterminer la tension dans la ligne de connexion et pour détecter le défaut lorsque la tension déterminée remplit les critères prédéfinis, l'unité de diagnostic (4) possédant deux convertisseurs analogiques (42, 43) qui sont montés en parallèle l'un à l'autre entre une extrémité de la ligne de connexion et une première unité de traitement (44) et qui sont configurés pour détecter respectivement des défauts différents.

2. Arrangement de tachygraphe selon la revendication 1, le défaut étant un court-circuit dans la ligne de connexion ou une interruption de la ligne de connexion.

3. Arrangement de tachygraphe selon la revendication 2, un court-circuit étant détecté dans la ligne de connexion lorsque la tension déterminée est de 0 V.

4. Arrangement de tachygraphe selon la revendication 2 ou 3, une interruption de la ligne de connexion étant détectée lorsque la tension déterminée est de 3,2 V.

5. Arrangement de tachygraphe selon l'une des revendications précédentes, la génération d'un avertissement présentant au moins l'un des éléments suivants :
un avertissement visuel ; et
un avertissement sonore.

6. Arrangement de tachygraphe selon l'une des revendications précédentes, l'antenne (1) et l'unité de traitement (2) étant disposées à distance l'une de l'autre.

7. Arrangement de tachygraphe selon la revendication 6, la ligne de connexion entre l'antenne (1) et l'unité de traitement (2) présentant une longueur d'environ un mètre ou plus.

8. Procédé pour faire fonctionner un arrangement d'antenne comprenant une antenne (1) et une unité de traitement (2), ledit arrangement d'antenne faisant partie d'un arrangement de tachygraphe selon l'une des revendications précédentes, le procédé comprenant :
détermination, au moyen d'une unité de diagnostic (4), d'une tension dans une ligne de connexion entre l'antenne (1) et l'unité de traitement (2), à savoir une tension qui est appliquée à une entrée d'une unité de commande (5) d'un tachygraphe à laquelle est reliée la ligne de connexion ; et
détection d'un défaut lorsque la tension déterminée remplit des critères prédéfinis ; des mesures supplémentaires étant prises lorsqu'un défaut a été détecté et que l'unité de traitement (2) se trouve dans un état de fonctionnement qui n'est pas un état de veille, les mesures supplémentaires présentant au moins l'une des suivantes :
génération d'un avertissement ; et
enregistrement d'un message d'erreur dans une mémoire ;
et l'unité de diagnostic (4) possédant au moins un convertisseur analogique (42, 43), lequel détermine la tension dans la ligne de connexion et détecte le défaut lorsque la tension déterminée remplit les critères prédéfinis, l'unité de diagnostic (4) possédant deux convertisseurs analogiques (42, 43) qui sont montés en parallèle l'un à l'autre entre une extrémité de la ligne de connexion et une première unité de traitement (44) et qui sont configurés pour détecter respectivement des défauts différents.

9. Procédé selon la revendication 8, le procédé comprenant en outre : détermination de la caractéristique d'antenne.
